## Europäisches Patentamt

## European Patent Office

## Office européen des brevets

(19)

(11) Veröffentlichungsnummer: **0 179 257**
**B1**

(12) **EUROPÄISCHE PATENTSCHRIFT**

(45) Veröffentlichungstag der Patentschrift: ·
**03.05.89**

(51) Int. Cl.⁴: **H 04 R 25/02, H 05 K 3/00**

(21) Anmeldenummer: **85111617.8**

(22) Anmeldetag: **13.09.85**

(54) Kleinhörgerät.

(30) Priorität: **27.09.84 DE 8428488 U**

(43) Veröffentlichungstag der Anmeldung:
**30.04.86 Patentblatt 86/18**

(45) Bekanntmachung des Hinweises auf die Patenterteilung:
**03.05.89 Patentblatt 89/18**

(84) Benannte Vertragsstaaten:
**AT CH DE FR GB IT LI NL**

(56) Entgegenhaltungen:
**DE-A- 2 724 399**
**US-A- 4 354 065**

**FUNKSCHAU, Nr. 1, Januar 1982, Seite 58, München, DE;**
**R. BRAUN: "STARR-flexible Leiter-platten"**

(73) Patentinhaber: **Siemens Aktiengesellschaft Berlin und München, Wittelsbacherplatz 2, D-8000 München 2 (DE)**

(72) Erfinder: **Büttner, Gerhard, Lerchenstrasse 9, D-8521 Grossenseebach (DE)**

ACTORUM AG

## Beschreibung

Die Erfindung betrifft Kleinhörgeräte, insbesondere ein hinter dem Ohr zu tragendes (HdO)-Hörgerät nach dem Oberbegriff des Anspruchs 1. Solche Geräte sind etwa bekannt aus der US-PS 43 54 065.

Bei HdO-Hörgeräten, zu denen auch Geräte zählen, die als Ersatz für die Abwinkelung am Ende eines Brillengestells angebracht sind, ist bekanntlich wenig Raum vorhanden, um die für den Betrieb wichtigen Teile des Gerätes darin unterzubringen. Da die Grösse der Wandler, Steller und Stromquelle in ihrem Bedarf an Einbauraum kaum veränderbar ist, liegen auch Versuche zur günstigen Formung des Verstärkers vor. Nach obengenannter US-PS hat man z.B. die Teile des Verstärkers für Kleinhörgeräte auf mehreren Platten angebracht und diese über flexible Zwischenstücke miteinander verbunden. So wird ein Verstärker erhalten, der zusammengefaltet werden kann und wenig Raum benötigt. Dabei müssen aber besondere, auch Raum beanspruchende Massnahmen zur Halterung der an sich gegeneinander beweglichen Teile vorgesehen werden.

Weitere Gestaltungsmöglichkeiten von Verstärkern sind z.B. in der DE-A 27 24 399 und in dem Aufsatz «Starr-flexible Leiterplatten», in «FUNKSCHAU», Nr. 1, Januar 1982, Seite 58, München, BRD, beschrieben. Die Leiterplatten dieser Verstärker sind mit flexiblen Schichten (Folien) ausgebildet, die in die starren Leiterplatten integriert sind und als Kabelersatz die einzelnen starren Platten elektrisch verbinden. Obwohl solche Leiterplatten zunehmend in Hörgeräten verwendet werden, müssen einige Nachteile dabei in Kauf genommen werden. Die besondere Flexibilität der Leiterplatte erfordert aufwendige Halterungen im Hörgerätgehäuse. Dies erschwert wiederum den Einbau der Leiterplatte und vermindert den für andere Bauelemente vorhandenen Innenraum im Gehäuse.

Die Erfindung hat sich die Aufgabe gestellt, bei einem Kleinhörgerät der eingangs genannten Art ohne die Halterung gefalteter Verstärkerteile auszukommen und trotzdem eine grosse Fläche zur Anbringung der Bauelemente zu bekommen. Diese Aufgabe wird erfindungsgemäss durch die im kennzeichnenden Teil des Anspruchs 1 angegebenen Massnahmen gelöst. Vorteilhafte Weiterbildungen sind Gegenstände der Unteransprüche.

Die Erfindung geht davon aus, dass bei gebogener Struktur, die insbesondere bei HdO-Geräten für den Einbau des Verstärkers zur Verfügung steht, mehr erreicht werden kann, wenn man ein Mehrschichtenverstärkersystem verwendet. Die gebogene Fläche kann durch die Anordnung mehrerer Verstärkerschichten besser genutzt werden. Die Anordnung des Verstärkers kann dazu auch noch in mehrere Baugruppen aufgeteilt sein, zwischen denen Biegezonen von Bauelementen freigelassen sind. Im Schichtensystem können die Baugruppen an einer Zwischenschicht liegen, die auch die Biegezonen zwischen den Gruppen überbrückt.

Durch die erfindungsgemässe Verwendung eines im Mehrschichtsystem aufgebauten Verstärkers braucht man keine Faltung und keine Halterung der gefalteten Teile gegeneinander, so dass eine Vereinfachung des Aufbaus erreicht ist.

Bei Verwendung eines Dreischichtensystems kann man in den beiden äusseren Schichten Bauelemente unterbringen und die Zwischenschicht als sogenannte neutrale Schicht nur mit Leiterbahnen versehen. Dies hat den Vorteil, dass die Biegezonen des Verstärkers in Bereiche gelegt sind, die keine Bauteile tragen und daher weniger spröde sind, so dass sie weniger leicht brechen als die eigentlichen Träger der Verstärkerbauteile. Ausserdem erhält man durch den Schichtenaufbau genügend Fläche, Teile des Verstärkers auch in der Form von Chips auszubilden, d.h. Bauelemente zu verwenden, die nur Anlötstellen haben und daher mehr Fläche beanspruchen als konventionelle, mit Anlötbeinen versehene Bauelemente, die aber wesentlich preiswerter zu haben und zu verarbeiten sind.

Die Teile eines Verstärkers für ein HdO-Hörgerät lassen sich, wie Versuche gezeigt haben, auf drei Baugruppen in jeweils zwei Bauelementeschichten unterbringen. Die mittlere der nebeneinanderliegenden Baugruppen kann ein Justiersystem enthalten, das neben Justierstellern für eine Einwirkung auf den übertagenen Bereich von Frequenzen und auf die Dynamik eine Induktionsaufnahmespule enthält. Dies hat sich als günstig erwiesen, weil bei der gebogenen Anordnung des Verstärkers für diese im mittleren Bereich der Anordnung liegende Baugruppe eine Lage gefunden ist, die einen Zugriff zu den Justierstellern ermöglicht, für den in der Wand des Gerätegehäuses eine Öffnung mit einer Verschlussklappe vorgesehen sein kann.

Eine aus drei Baugruppen bestehende Anordnung kann an beiden Enden über die drei Baugruppen hinausragende Teile einer verbindenden Zwischenschicht enthalten. Dabei können an dieser Schicht Verbindungsleitungen einerseits zu Kontakten zur Versorgungsstromquelle oder zu einem Lautstärkeregler und andererseits zu einem Aus- und Einschalter und zu den Wandlern geführt sein.

Weitere Einzelheiten und Vorteile der Erfindung werden nachfolgend anhand der in den Figuren dargestellten Ausführungsbeispiele weiter erläutert.

In der Figur 1 ist ein perspektivisches Schaubild eines mit einem erfindungsgemäss ausgebildeten Verstärker ausgestatteten HdO-Hörgerätes gezeichnet,

in der Figur 2 die Anordnung des Gerätes am Ohr,

in der Figur 3 teilweise aufgebrochen eine Seitenansicht,

in der Figur 4 eine Seitenansicht des bei vorgenanntem Gerät benutzten Verstärkers,

in der Figur 5 die Draufsicht auf seine obere Schicht,

in der Figur 6 die Draufsicht auf seine Zwischenschicht und

in der Figur 7 die Unteransicht des Verstärkers nach Figur 4.

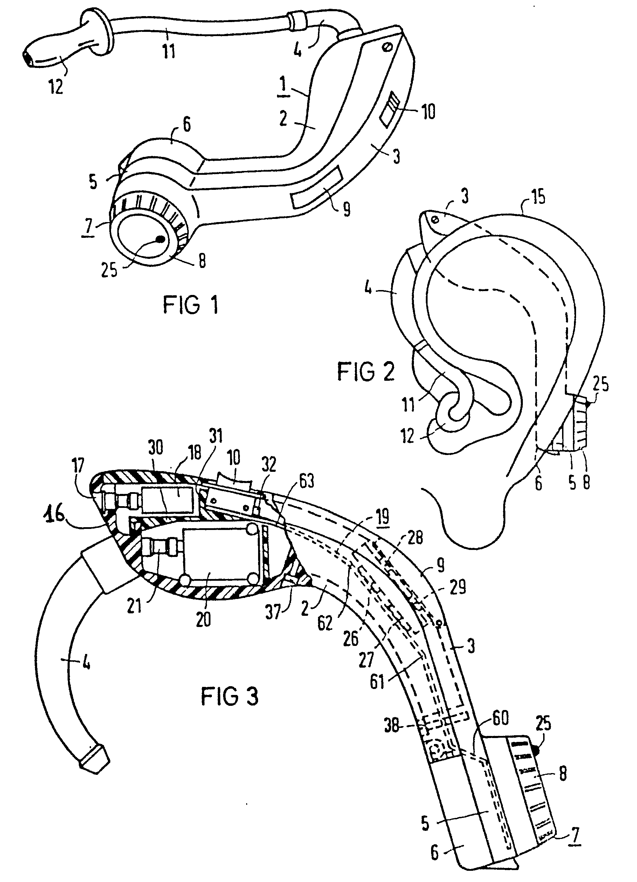

In der Figur 1 ist mit 1 das Gehäuse eines Hinterohrhörgerätes bezeichnet, das aus einer Schale 2 und einer Schale 3 zusammengesetzt ist. Am oberen Ende des Gehäuses 1 befindet sich ein Traghaken 4 und am gegenüberliegenden unteren Ende ein Behälter 5 für eine Stromquelle. Dieser Behälter 5 ist mit einem Deckel 6, der nach der Innenseite des gebogenen Gehäuses aufklappbar ist, verschlossen. Nach der Aussenseite liegt am Behälter 5 ein Lautstärkeregler 7, der an seinem Einstellrädchen 8 erkennbar ist.

Der äussere Bogen der Schale 3 weist etwa in seiner Mitte eine Verschlussklappe 9 auf und zwischen dieser und dem oberen Ende einen Schalter 10. Am Ende des von einem Schalleitungskanal durchsetzten Traghakens 4 ist ein Schlauch 11 angeschlossen, der in eine elastische Ohrolive 12 mündet, die zum Anschluss des Gerätes an den Ohrkanal ihres Benutzers dient.

Das Gerät wird, wie aus Figur 2 ersichtlich, am Ohr 15 derart getragen, dass es mit seinem Innenbogen an der Rückseite der Ohrwurzel anliegt. Mit dem Haken 4 wird es am oberen Ohransatz festgehalten. Wie aus Figur 3 ersichtlich, kann an der Stirnfläche 16 durch eine Öffnung 17 Schall zu einem Mikrofon 18 gelangen. Dort wird dieser in elektrische Signale umgesetzt. In einem im mittleren Teil des Gehäuses 1 liegenden Verstärker 19 werden diese Signale dann anhand der eingestellten Frequenzübertragungskurve in ihrer Intensität gesteigert und schliesslich einem Hörer 20 zugeführt. Von dort gelangt der aus den verstärkten Signalen erhaltene Schall über eine Leitung 21, den Traghaken 4, den Schlauch 11 und die Ohrolive 12 in das Gehör des Benutzers des Hörgerätes. Der Verstärker 19 wird von einer im Raum 5 untergebrachten Stromquelle mit Energie versorgt.

Die eigentliche Steuerung der zum Ohr gelangenden Lautstärke erfolgt am Stellerrädchen 8. Die Einstellung dieses Rädchens ist an der Lage einer anders als ihre Umgebung gefärbten Noppe 25 sichtbar und, da diese Noppe 25 über die Oberfläche des Stellerrädchens 8 vorsteht, auch fühlbar.

Der Verstärker 19 ist an Stellern 26 und 27, die über Einstelldrehelemente 28 und 29 in ihrer Wirkung veränderbar sind, auch in seiner Wirksamkeit hinsichtlich der Frequenzübertragungskurve, d.h. der durchgelassenen Frequenzverteilung und der Wirkung sehr hoher Schallintensitäten, durch eine einstellbare PC (peak clipping) beeinflusst.

Der Schalter 10 ist, wie aus Figur 3 ersichtlich, auf einer Platte 30 in angepassten Halterungen 31 und 32 befestigt. Er dient zum Ein- und Ausschalten des Gerätes und zum Einschalten der Signalaufnahme mittels Mikrofon 18 oder einer mit den Stellern 26 und 27 zu einer Baueinheit zusammengeschlossenen Induktionsaufnahmespule 34.

Der Verstärker 19 ist auf einer flexiblen Folie 40 aufgebaut, die an ihren grossen Flächen kupferne Leiterschichten 42 und 43 trägt, welche die Form gedruckter Schaltungen haben. Auf die Leiterbahnen der Schicht 43 folgt zur Unterseite hin eine Klebeschicht 45, die starre Halterungsplatten 46 bis 49 trägt, von denen die mit 47 bis 49 bezeichneten an ihrer von der Klebeschicht 45 abgewandten Seite mit einer kupfernen Leiterbahnenschicht 50 bis 52 bedeckt sind, auf die dann in der Form von Chips ausgebildete Bauelemente 53 an den Stellen 53.1 aufgelötet sind.

Nach der anderen Seite hin folgen auf die Leiterbahnen der Schicht 42 Bauelemente, die in üblicher Weise mit ihren Anschlussbeinen an der Folie 40 angelötet sind. Dies sind etwa Kondensatoren 54, ein integrierter Schaltkreis 54.2, der Lautstärkeregler 7 mit seinem Stelleranschluss 8.1 und der Schalter 10 ebenso wie die Abgriffe 55 und 56, die zum Anschluss einer Stromquelle in den Batteriehalter 6 reichen.

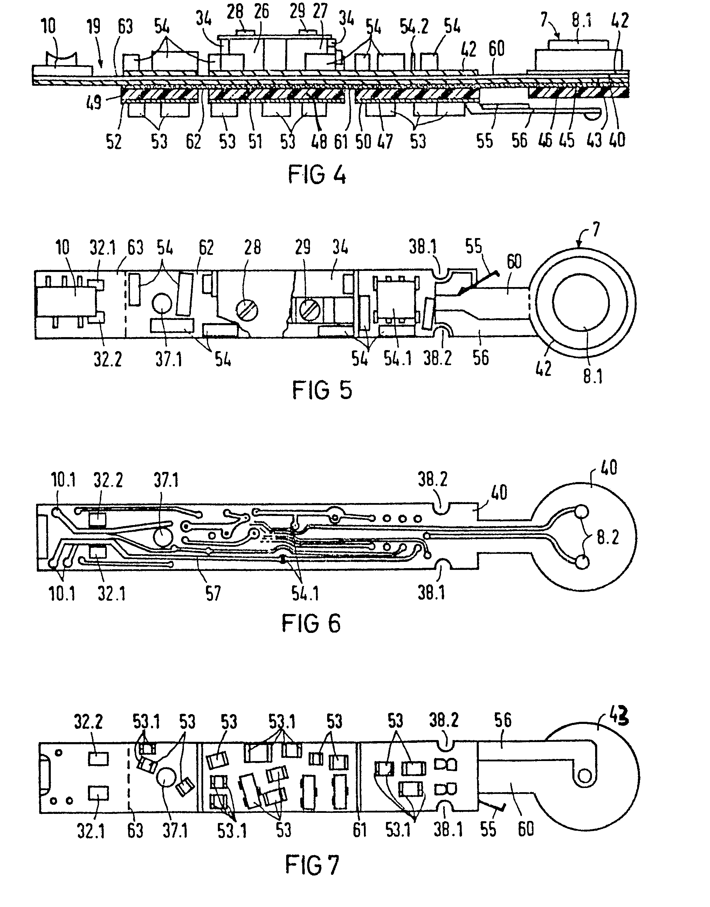

In der Figur 6 ist ersichtlich, dass die leitfähige Belegung 43 der Folie 40 in Leiterbahnen 57 aufgelöst ist, die Anlötungen 10.1 des Schalters 10 und die mit 54.1 bezeichneten Anlötungen der Bauelemente 54 ebenso wie die Anlötungen 8.2 des Lautstärkestellers 7 aufweisen.

Zwischen den Platten 46 bis 49 verbleiben Biegezonen 60 bis 63. An den Ansichten des Verstärkers 19 (Figuren 5 bis 7) sind auch noch Stellen zur Befestigung des Verstärkers 19 im Gehäuse 1 ersichtlich. Dies sind der Durchbruch 37.1 der Schraube 37 (Figur 3) und seitliche Ausnehmungen 38.1 und 38.2 für die Schrauben, von denen diejenige, die mit 38 bezeichnet ist, in Figur 3 sichtbar ist. Sie verdeckt die dahinter entlang der anderen Seite des Gehäuses 1 liegende zweite Schraube. Ausserdem ist der Verstärker 19 mittels Öffnungen 32.1 und 32.2 an der durch die Stiften 32 (Figur 3) gebildeten hinteren Halterung des Schalters 10 eingehängt.

In Figur 3 ist die Lage des Verstärkers 19 im Gehäuse 1 eingezeichnet. Sein Aufbau erstreckt sich vom Schalter 10 bis zum Lautstärkeregler 7. Dabei ergibt sich durch Abknickungen an den Biegezonen 60 bis 63 die gebogene Anpassung des Verstärkers 19 an die Form des Gehäuses 1.

**Patentansprüche**

1. Kleinhörgerät mit Eingangswandler (18), Verstärker (19) und Bedienungselementen (7, 10, 28, 29) sowie Stromquelle und Ausgangswandler (20), wobei wenigstens ein Teil des Verstärkers auf gelenkig miteinander verbundenen Montageflächen (46 bis 49) angebracht ist und die gelenkigen Verbindungen (60 bis 63) eine mit elektrisch leitenden Bahnen versehene flexible Unterlage haben, dadurch gekennzeichnet, dass der Verstärker als Mehrschichtensystem ausgebildet ist, das wenigstens drei Schichten (42, 43, 50 bis 52) umfasst, von denen die zwei äusseren (42, 50 bis 52) Bauelemente tragen, an einer mit Leiterbahnen (57) versehenen, sogenannten neutralen Zwischenschicht (43) liegen und an mehreren, einander gegenüberliegenden Stellen in Baugruppen unterteilt sind und dass die mechanische Festigkeit der Zwischenschicht eine Verformung der Anordnung zulässt.

2. Kleinhörgerät nach Anspruch 1, dadurch gekennzeichnet, dass wenigstens in einer der beiden äusseren Schichten eines Dreischichtensystem-Verstärkers Bauelemente in der Form von Chips (53) an Leiterbahnen (50 bis 52) angelötet sind.

3. Kleinhörgerät nach Anspruch 1, dadurch gekennzeichnet, dass von den äusseren Schichten die eine nur konventionelle Bauteile enthält und die andere nur Chips.

4. Kleinhörgerät nach Anspruch 1, dadurch gekennzeichnet, dass die Zwischenschicht (43) über die Baugruppen hinausreicht und an einem Ende Leiterbahnen (57) bis zu einem Schalter (10) aufweist, während am anderen Ende Leiterbahnen bis zu Anlötungen (8.2) eines Lautstärkestellers (7) reichen.

5. Kleinhörgerät nach Anspruch 1, dadurch gekennzeichnet, dass bei Unterteilung in drei Baugruppen die mittlere davon mit einer Kombination aus wenigstens zwei Stellern (26, 27) und einer Induktionsaufnahmespule (34) versehen ist.

6. Kleinhörgerät nach Anspruch 1, dadurch gekennzeichnet, dass die Leiterbahnen (57) der Zwischenschicht (43) Teile einer gedruckten Schaltung sind, die mit den in den Baugruppen enthaltenen Bauelementen zusammenwirken.

7. Kleinhörgerät nach Anspruch 1, dadurch gekennzeichnet, dass die gelenkigen Verbindungen (60 bis 63) als Biegezonen, die keine Bauelemente tragen, ausgebildet sind.

8. Kleinhörgerät nach Anspruch 1, dadurch gekennzeichnet, dass das Hörgerät ein hinter dem Ohr zu tragendes Gehäuse (1) mit einer gebogenen Struktur aufweist und dass der Verstärker (19) diese gebogene Struktur nachbildet.

## Revendications

1. Appareil miniature de correction auditive comportant un transducteur d'entrée (18), un amplificateur (19) et des éléments de commande (17, 18, 29) ainsi qu'une source de courant et un transducteur de sortie (20), dans lequel au moins une partie d'un amplificateur est montée sur des surfaces de montage (46 à 49) reliées entre elles de façon articulée et les liaisons articulées (60 à 63) possèdent un support flexible pourvu de voies électriquement conductrices, caractérisé par le fait que l'amplificateur est réalisé sous la forme d'un système à couches multiples, qui comporte au moins trois couches (42, 43, 50 à 52), parmi lesquelles les deux couches extérieures (42, 50 à 52) portent des composants, sont situées sur une couche intermédiaire dite neutre (43), pourvue de voies conductrices (57), et sont subdivisées en plusieurs emplacements situés en vis-à-vis les uns des autres, pour former des modules, et que la rigidité mécanique de la couche intermédiaire autorise une déformation du dispositif.

2. Appareil miniature de correction auditive suivant la revendication 1, caractérisé par le fait que des composants se présentant sous la forme de microplaquettes (53) sont fixés par soudage à des voies conductrices (50 à 52), au moins dans l'une des deux couches extérieures d'un amplificateur en forme de système à trois couches.

3. Appareil miniature de correction auditive suivant la revendication 1, caractérisé par le fait que parmi les couches extérieures, l'une contient uniquement des composants classiques et l'autre uniquement des micro-plaquettes.

4. Appareil miniature de correction auditive suivant la revendication 1, caractérisé par le fait que la couche intercalaire (43) s'étend au-delà des modules et possède, sur une extrémité, des voies conductrices (57) s'étendant jusqu'à un interrupteur (10), tandis qu'au niveau de l'autre extrémité, des voies conductrices s'étendent jusqu'aux soudures (8.2) d'un régulateur d'intensité sonore (7).

5. Appareil miniature de correction auditive suivant la revendication 1, caractérisé par le fait que, dans le cas de la subdivision en trois modules, le module médian est équipé d'une combinaison formée par au moins deux régulateurs (26, 27) et d'une bobine de détection à induction (34).

6. Appareil miniature de correction auditive suivant la revendication 1, caractérisé par le fait que les voies conductrices (57) de la couche intermédiaire (43) constituent des parties d'un circuit imprimé, qui coopèrent avec les composants contenus dans les modules.

7. Appareil miniature de correction auditive suivant la revendication 1, caractérisé par le fait que les liaisons articulées (60 à 63) sont réalisées sous la forme de zones de pliage qui ne portent aucun composant.

8. Appareil miniature de correction auditive suivant la revendication 1, caractérisé par le fait que l'appareil de correction auditive comporte un boîtier (1) destiné à être porté derrière l'oreille et possédant une structure recourbée, et que l'amplificateur (19) est adapté à cette structure recourbée.

## Claims

1. Miniature hearing aid with input transducer (18), amplifier (19) and operating elements (7, 10, 28, 29) and also current source and output transducer (20), in which at least one part of the amplifier is provided on assembly surfaces (46 to 49) which are connected with each other in an articulated manner and the articulated connections (60 to 63) have a flexible base which is provided with electrically conductive tracks, characterised in that the amplifier is developed as a multi-layer system which comprises at least three layers (42, 43, 50 to 52), of which the two outer layers (42, 50 to 52) carry components, lie on a socalled neutral intermediate layer (43) which is provided with strip conductors (57), and are subdivided into assemblies at several opposing points and in that the mechanical strength of the intermediate layer permits a deformation of the arrangement.

2. Miniature hearing aid according to claim 1, characterised in that components in the form of chips (53) are soldered onto strip conductors (50 to 52) at least in one of the two outer layers of a three-layer system amplifier.

3. Miniature hearing aid according to claim 1,

characterised in that of the outer layers one contains only conventional components and the other contains only chips.

4. Miniature hearing aid according to claim 1, characterised in that the intermediate layer (43) reaches beyond the assemblies and has at the one end strip conductors (57) as far as a switch (10), whilst at the other end strip conductors reach as far as solderings (8.2) of a sound level regulating unit (7).

5. Miniature hearing aid according to claim 1, characterised in that in the case of subdivision into three assemblies the central one thereof is provided with a combination of at least two regulating units (26, 27) and an induction take-up spool (34).

6. Miniature hearing aid according to claim 1, characterised in that the strip conductors (57) of the intermediate layer (43) are parts of a printed circuit, said parts cooperating with the components contained in the assemblies.

7. Miniature hearing aid according to claim 1, characterised in that the articulated connections (60 to 63) are developed as bending zones which carry no components.

8. Miniature hearing aid according to claim 1, characterised in that the hearing aid has a housing (1) to be worn behind the ear with a bent structure and in that the amplifier (19) reproduces this bent structure.

1/2

FIG 1

FIG 2

FIG 3

3/2

FIG 4

FIG 5

FIG 6

FIG 7